# EUROPEAN PATENT SPECIFICATION

(11) **EP 0 794 459 B1**
(45) Date of publication and mention of the grant of the patent: **12.07.2000**
(21) Application number: 96200647.4
(22) Date of filing: 09.03.1996
(51) Int. Cl.: G03F 7/07

(54) **Method for making a printing plate according to the silver salt diffusion transfer process**
Verfahren zur Herstellung einer Druckplatte nach dem Silbersalz-Diffusionübertragungsverfahren
Méthode de fabrication d'une plaque d'impression selon le procédé de diffusion-transfert de sel d'argent

(43) Date of publication of application: 10.09.1997
(73) Proprietor: AGFA-GEVAERT N.V., 2640 Mortsel (BE)
(72) Inventor: Vaes, Jos, 2640 Mortsel (BE)

(56) References cited:
- EP-A- 0 610 983
- EP-A- 0 628 877

## Description

### 1. Field of the invention.

The present invention relates to a method for making improved lithographic printing plates according to the silver salt diffusion transfer process.

### 2. Background of the invention.

The principle of the silver complex diffusion transfer process (hereinafter referred to as DTR process) is well known from the description in U.S. Pat. No. 2,352,014 and in the book "Photographic Silver Halide Diffusion Processes" by André Rott and Edith Weyde - The Focal Press - London and New York, (1972).

In the DTR process, the silver complex is imagewise transferred by diffusion from a silver halide emulsion layer to an image receptive layer and transformed therein into a silver image generally in the presence of physical development nuclei. For this purpose, the imagewise exposed silver halide emulsion layer is arranged so as to be in contact with or is brought into contact with the image receptive layer in the presence of a developing agent and a solvent for the silver halide, thereby to convert the unexposed silver halide into a soluble silver complex. In the exposed areas of the silver halide emulsion layer, the silver halide is developed into silver which is insoluble and, hence, cannot diffuse. In the unexposed areas of the silver halide emulsion layer, the silver halide is converted into a soluble silver complex and is transferred to an image receptive layer wherein the silver complex forms a silver image generally in the presence of physical development nuclei.

The DTR-process can be used for making lithographic printing plates. A DTR-image bearing material can be used as a planographic printing plate wherein the DTR-silver image areas form the water-repellant ink-receptive areas on a water-receptive ink-repellant surface. The DTR-image can be formed in the image-receiving layer of a sheet or web material which is a separate element with respect to the photographic silver halide emulsion material (a so-called two-sheet DTR element) disclosed in e.g. DE-A-2.346.378 or in the image-receiving layer of a so-called single-support-element, also called mono-sheet element, which contains at least one photographic silver halide emulsion layer integral with an image-receiving layer in water permeable relationship therewith. It is the latter mono-sheet version which is preferred for the preparation of offset printing plates by the DTR method.

As for other printing plates it is required that the mono-sheet DTR offset printing plates have good printing properties as well when prepared in fresh as in exhausted aqueous alkaline solution e.g. a high printing endurance, good ink acceptance in the printing areas and no ink acceptance in the non-printing areas (no staining). However DTR offset printing plates prepared in exhausted aqueous alkaline solution shows unreproducible and unacceptable printing results depending of the exhaustion degree of the used aqueous alkaline solution. The degree of exhaustion of the aqueous alkaline solution is not only a function of the amount of processed imaging element (i.e. the element carrying the silver halide emulsion layer) but also of the rhythm of the processing . Furthermore the aqueous alkaline solution need to be refreshed regularly and this leads to a serious amount of liquid waste. A solution for said problems is a method of preparing said DTR offset printing plates by a method in which the aqueous alkaline solution is supplied in a constant way only to the face of the imaging element on which a silver halide emulsion is applied. This way of processing does not only have the advantage of always using fresh aqueous alkaline solution but the amount of waste of aqueous alkaline solution is considerably reduced. However it has been found that said way of processing leads to printing plates with unequal and unacceptable printing properties. So, said way of processing could still use some improvement.

### 3. Summary of the invention

It is an object of the present invention to provide a method for obtaining a lithographic printing plate according to the silver salt diffusion transfer process with excellent lithographic printing properties, irrespective of the amount of imaging elements processed in the aqueous alkaline solution.

It is a further object of the present invention to provide a method for obtaining a lithographic printing plate according to the silver salt diffusion transfer process with a lesser consumption of aqueous alkaline solution and thus a lowered cost price and a more ecological production process.

According to the present invention there is provided a method for obtaining a lithographic printing plate according to the silver salt diffusion transfer process comprising the steps of:
(a) image-wise exposing an imaging element comprising on a support (i) a photosensitive layer comprising one or more silver halide emulsions and (ii) an image receiving layer containing physical development nuclei being in water permeable relationship with said photosensitive layer
(b) applying an aqueous alkaline solution to the imaging element in the presence of (a) developing agent(s) being applied by said aqueous alkaline and/or being present in the said imaging element and in the presence of (a) silver halide solvent(s) to form a silver image in said image receiving layer,
(c) optionally applying a neutralizing solution to the imaging element,
said aqueous alkaline solution being applied by a method in which said solution is supplied in a constant way only to the face of the imaging element on which a silver halide emulsion is applied, characterized in that said aqueous alkaline solution is applied in an amount so that the molar amount of alkali applied per m² is at least 3 times the molar amount of silver halide per m² in the imaging element and the total molar amount of developing agent applied per m² of imaging element and/or being present per m² in the imaging element is at least 0.60 times the molar amount of silver halide per m² in the imaging element.

### 4. Detailed description of the invention.

It has been found that when a DTR-process is carried out in order to obtain a printing plate using the above described method a lithographic plate is obtained with excellent lithographic printing properties, irrespective of the amount of imaging elements processed in the aqueous alkaline solution with a lesser consumption of aqueous alkaline solution and thus a lowered cost price and a more ecological production process.

A developing agent in accordance with the invention is preferably a compound which theoretically can reduce 2 moles of silver halide per mole of compound.

The molar amount of alkali applied per m² of imaging element is preferably at least 5 times, more preferably at least 7 times the molar amount of silver halide per m² in the imaging element. The upper limit of alkali applied per m² of imaging element is not so important but is for practical and economical reasons preferably lower than 30 times, more preferably lower than 20 times the molar amount of silver halide per m² in the imaging element.

The total molar amount of developing agent applied per m² of imaging element and/or being present per m² in the imaging element is preferably at least 0.70 times, more preferably at least 0.80 times the molar amount of silver halide per m² in the imaging element. The upper limit of the total molar amounts of developing agent applied per m² of imaging element and/or being present per m² in the imaging element is not so important but is for practical and economical reasons preferably lower than 5 times, more preferably lower than 3 times the amount of silver halide per m² in the imaging element.

The alkaline processing liquid used for developing the imaging element in accordance with the method of the present invention preferably contains a silver halide solvent. Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones and thiosulfates. Silver halide solvents that are preferably used in connection with the present invention are thiocyanates and alkanolamines.

Alkanolamines that are suitable for use in connection with the present invention may he of the tertiary, secundary or primary type. Examples of alkanolamines that may be used in connection with the present invention correspond to the following formula: 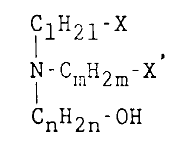 wherein X and X' independently represent hydrogen, a hydroxyl group or an amino group, l and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.
According to the present invention the alkanolamines are preferably present in the alkaline processing liquid. However part or all of the alkanolamine can be present in one or more layers of the imaging element.

A further suitable type of silver halide solvents are thioether compounds. Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contains an oxygen bridge and t represents an integer from 0 to 10. Examples of thioether compounds corresponding to the above formula are disclosed in e.g. US-P-4.960.683 and EP-A-554.585.

Still further suitable silver halide solvents are meso-ionic compounds. Preferred meso-ionic compounds for use in connection with the present invention are triazolium thiolates and more preferred 1,2,4-triazolium-3-thiolates.

According to a preferred embodiment of the present invention at least part and most preferably all of the meso-ionic compound is present in the alkaline processing liquid used for developing the image-wise exposed imaging element. Preferably the amount of meso-ionic compound in the alkaline processing liquid is between 0.1 mmol/l and 25 mmol/l and more preferably between 0.5 mmol/l and 15 mmol/l and most preferably between 1 mmol/l and 8 mmol/l.

However the meso-ionic compound may be incorporated in one or more layers comprised on the support of the imaging element. The meso-ionic compound is in that case preferably contained in the imaging element in a total amount between 0.1 and 10 mmol/m², more preferably between 0.1 and 5 mmol/m² and most preferably between 0.5 and 1.5 mmol/m². More details are disclosed in EP-A-0,554,585

According to the present invention the alkaline processing preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Preferred hydrophobizing agents are mercapto-1,3,4-thiadiazoles as described in DE-A 1,228,927 and in US-P 4,563,410, 2-mercapto-5-alkyl-oxa-3,4-diazole, 3-mercapto-1,2,4-triazoles and aryl substituted mercaptotetrazoles.

Particularly preferred hydrophobizing agents in connection with the present invention are at least 5 carbon atoms comprising aliphatic chain substituted mercaptotetrazoles, more in particular those according to the following formula (I): 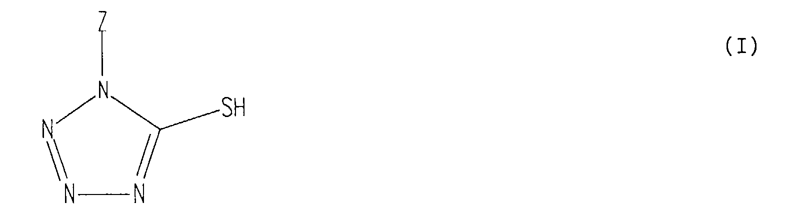 wherein Z represents an alkylaryl, a substituted or unsubstituted alkenyl, a substituted or unsubstituted alkynyl and most preferably a substituted or unsubstituted alkyl.

Specific examples of hydrophobizing agents according to formula (I) are listed in table 1.

**Table 1**

| compound no. | Z in formula (I) |
|---|---|
| 1 | CH₂CONH-n.C₆H₁₃ |
| 2 | CH₂CON(n.C₄H₉)₂ |
| 3 | n.C₆H₁₃ |

Also particularly preferred compounds are 5-n-heptyl-2-mercapto-1,3,4,-oxadiazol and 3-mercapto-4-acetamido-5-n-heptyl-1,2,4-triazole.

The hydrophobizing agents are contained in the alkaline processing solution in an amount of preferably at least 0.1 g/l, more preferably at least 0.2 g/l and most preferably at least 0.3 g/l. The maximum amount of hydrophobizing agents will be determined by the type of hydrophobizing agent, type and amount of silver halide solvents etc.. Typically the concentration of hydrophobizing agent is preferably not more than 1.5 g/l and more preferably not more than 1 g/l.

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help maintain the pH and serve as a silver halide complexing agent.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid. Preferably, the alkaline processing liquid used in the development of an imaging element in accordance with the present invention is an activator.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidone-type developing agent and/or p-monomethylaminophenol. Particularly useful auxiliary developing agents are of the phenidone type e.g. 1-phenyl-3-pyrazolidone, 1-phenyl-4-monomethyl-3-pyrazolidone, and 1-phenyl-4,4-dimethyl-3-pyrazolidone. However other developing agents can be used.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

The aqueous alkaline solution which is supplied according to the invention in a constant way only to the face of the imaging element on which a silver halide emulsion is applied has preferably a viscosity of at least 5 mPa s, more preferably of at least 7 mPa s at a temperature of 25°C, preferably by adding thickening agents preferably hydroxyethylcellulose and carboxymethylcellulose in an amount depending of the thickening agent but being preferably in the range between 1 and 10 g/l.

The aqueous alkaline solution which is supplied according to the invention in a constant way only to the face of the imaging element on which a silver halide emulsion is applied has preferably a dynamic surface tension at 1 s and at 25°C of at most 50 mN/m , more preferably of at most 40 mN/m. Said dynamic surface tension is obtained by adding surface-active agents to the aqueous alkaline solution, preferably compounds containing perfluorinated alkyl groups are used. More preferably said surface-active agents containing perfluorinated alkyl groups are used in an amount between 0.01 and 1 g/l, most preferably in an amount between 0.03 and 0.3g/l.

The aqueous alkaline solution which is supplied according to the invention in a constant way only to the face of the imaging element on which a silver halide emulsion is applied can be supplied on the imaging element by known means e.g. a feed roller, a bar coater, etc..

According to one embodiment of the present invention for obtaining a lithographic printing plate an imaging element comprising in the order given on a support a silver halide emulsion layer and an image receiving layer is image-wise or information-wise exposed and subsequently developed in the presence of (a) developing agent(s) and (a) silver halide solvent(s) using an alkaline processing liquid as described above.

According to the present invention the imaging element can be information-wise exposed in an apparatus according to its particular application. A wide choice of cameras for exposing the photosensitive silver halide emulsion exists on the market.
Horizontal, vertical and darkroom type cameras and contact-exposure apparatus are available to suit any particular class of reprographic work. The imaging element in accordance with the present invention can also be exposed with the aid of i.a. laser recorders, laser diodes and cathode rays tubes.

The development step is preferably followed by a neutralization of the surface of the imaged element by guiding the element through a neutralization liquid having a pH between 4 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups.

In a preferred embodiment the imaging element in connection with the present invention for preparing a lithographic printing plate essentially contains on a support in the order given a photosensitive layer containing silver halide and an image receiving layer containing physical development nuclei in water permeable relationship with said emulsion layer.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or the complexed silver.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. poly(ethylene terephthalate) film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used in accordance with the present invention.

The photosensitive layer used according to the present invention may be any layer comprising a hydrophilic colloid binder and at least one photosensitive silver halide emulsion.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

According to the present invention the emulsion or emulsions preferably consist principally of silver chloride while a fraction of silver bromide may be present upto 40 mole %, When the fraction of silver bromide is 5 mole% or more, the emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

According to the present invention said emulsion or emulsions preferably contains silver iodide in an amount between 0.01 to 1 mole%, more preferably in an amount between 0.05 and 0.5 mole%.

According to the invention, said emulsions contains more preferably at least 90 mole%, most preferably at least 95 mole% of silver chloride.

The average size of the silver halide grains may range from 0.10 to 0.70 µm , preferably from 0.25 to 0.45 µm.

Preferably during the precipitation stage Iridium and/or Rhodium containing compounds or a mixture of both are added. The concentration of these added compounds ranges from 10⁻⁸ to 10⁻³ mole per mole of AgNO₃, preferably between 10⁻⁷ and 10⁻⁵ mole per mole of AgNO₃. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by a red light emitting source, e.g. a LED or a HeNe laser a red sensitizing dye is used. In case of exposure by an argon ion laser a blue sensizing dye is incorporated. In case of exposure by a semiconductor laser special spectral sensitizing dyes suited for the near infra-red are required. Suitable infra-red sensitizing dyes are disclosed in i.a. US-P Nos 2,095,854, 2,095,856, 2,955,939, 3,482,978, 3,552,974, 3,573,921, 3,582,344, 3,623,881 and 3,695,888. To enhance the sensitivity in the red or near infra-red region use can be made of so-called supersensitizers in combination with red or infra-red sensitizing dyes. Suitable supersensitizers are described in Research Disclosure Vol 289, May 1988, item 28952. A preferred green sensitizing dye, red sensitizing dye, blue sensitizing dye, infra-red sensitizing dye and supersensitizer are disclosed in EP-A-554,585.

The spectral sensitizers can be added to the photographic emulsions in the form of an aqueous solution, a solution in an organic solvent or in the form of a dispersion.

The silver halide emulsions may contain the usual stabilizers e.g. azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value near the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

In an especially preferred embodiment the emulsion layer contained in the imaging element contains a compound which comprises in its molecular structure a group capable of adsorbing to silver halide and a group capable of reducing silver halide. Compounds of this kind have been disclosed in EP-A-449340. In this way a combination of a stabilizing and a development activating function in one compound is achieved.

More details about the composition, preparation and coating of silver halide emulsions can be found in e.g. Product Licensing Index, Vol. 92, December 1971, publication 9232, p. 107-109.

The layer containing physical development nuclei can be free of hydrophilic binder but preferably comprises amounts upto e.g. 80% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

The amount of nuclei used in the image receiving layer is preferably between 0.2 mg/m² and 20 mg/m², more preferably between 0.4 mg/m² and 18 mg/m², most preferably between 0.6 mg/m² and 15 mg/m²

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P-2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value near the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the vinylsulfone type e.g. 1,3-vinylsulphonyl-2-propanol, methylenebis(sulfonylethylene), aldehydes e.g. formaldehyde, glyoxal, and glutaraldehyde, N-methylol compounds e.g. dimethylolurea and methyloldimethylhydantoin, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

According to another embodiment of the present invention a lithographic printing plate can be obtained by means of the DTR-process using an imaging element comprising in the order given a hydrophilic surface of a support, a layer of physical development nuclei and a silver halide emulsion layer in water permeable relationship with said layer of physical development nuclei.

Said hydrophilic surface of a support can be a hardened hydrophilic layer, containing a hydrophilic binder and a hardening agent coated on a flexible support.

Such hydrophilic binders are disclosed in e.g. EP*-*A 450,199, which therefor is incorporated herein by reference. Preferred hardened hydrophilic layers comprise partially modified dextrans or pullulan hardened with an aldehyde as disclosed in e.g. EP*-*A 514,990 which therefor is incorporated herein by reference. More preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

Flexible supports e.g. a paper support or a resin support are described above.

Said hydrophilic surface of a support may be a hydrophilic metallic support e.g. an aluminum foil.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 µm, an anodization layer with a thickness between 0.4 and 2.0 µm and is sealed with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like H₂SO₄, H₃PO₄, that if desired, contain additionally one or more corrosion inhibitors such as Al(NO₃)₃, AlCl₃, boric acid, chromic acid, sulfates, chlorides, nitrates, monoamines, diamines, aldehydes, phosphates, H₂O₂, etc. ...

Electrochemical graining in connection with the present invention can be performed using single-phase and three-phase alternating current. The voltage applied to the aluminum plate is preferably 10-35 V. A current density of 3-150 Amp/dm² is employed for 5-240 seconds. The temperature of the electrolytic graining solution may vary from 5-50°C. Electrochemical graining is carried out preferably with an alternating current from 10 Hz to 300 Hz.

The roughening is preferably preceded by a degreasing treatment mainly for removing greasy substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulfuric acid, phosphoric acid, oxalic acid, chromic acid or organic acids such as sulfamic, benzosulfonic acid, etc. or mixtures thereof. An electrolyte concentration from 1 to 70 % by weight can be used within a temperature range from 0-70°C. The anodic current density may vary from 1-50 A/dm² and the voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36 °C and pH 6 has a viscosity lower than 20 mPas at a shearing rate of 1000 s^{*-*}¹ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 g/m², dried for 3 days at 57 C° and 35% R.H. and dipped in water of 30 C°, said gelatin layer is dissolved for more than 95 % by weight within 5 minutes.

The imaging element of the present embodiment may be imaged using an information-wise exposure in an apparatus according to its particular application as described above followed by a development step in the presence of development agent(s) and silver halide solvent(s) according to the invention so that a silver image is formed in the physical development nuclei layer. Subsequently the silver halide emulsion layer and any other optional hydrophilic layers are removed by e.g. rinsing the imaged element with water, preferably between 30°C and 50°C so that the silver image is exposed.

To facilitate the removal of the silver halide emulsion layer it is advantageous to provide a layer between the hydrophilic surface of a support and the silver halide emulsion layer comprising a hydrophilic non-proteinic film-forming polymer e.g. polyvinyl alcohol, polymer beads e.g. poly(meth)acrylate beads, mixtures thereof, particles of a water insoluble inorganic compound having a number average size not lower than 0.1 µm, alkali insoluble non-polymeric organic compounds having a melting point of at least 50°C and a number average size between 0.1 µm and 10 µm or particles of an alkali insoluble polymeric organic compound obtainable by polycondensation and having a number average size between 0.02 µm and 10 µm. Such type of layers are disclosed in EP-A-483415, EP-A-410500, EP-A-94203779.7, EP-A-95201713.5 and EP-A-95203052.6.

Finally said exposed imaged surface of the hydrophilic support is preferably treated with a finisher to enhance the water-receptivity of the non-image areas and to make the image areas oleophilic ink-receptive.

The lithographic composition often called finisher comprises at least one compound enhancing the ink-receptivity and/or lacquer-receptivity of the silver image and at least one compound that improves the ink-repelling characteristics of the hydrophilic surface.

Suitable ingredients for the finisher are e.g. organic compounds containing a mercapto group such as the hydrophobizing compounds referred to hereinbefore for the alkaline solution. Said (a) hydrophobizing agent(s) is(are) comprised in the finisher preferably in a total concentration between 0.1 g/l and 10 g/l, more preferably in a total concentration between 0.3 g/l and 3 g/l.

Additives improving the oleophilic ink-repellency of the hydrophilic surface areas are e.g. carbohydrates such as acid polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyvinyl alcohol and preferably polyglycols, being the reaction products of ethyleneoxide and/or propyleneoxide with water or an alcohol. Optionally, hygroscopic substances e.g. sorbitol, glycerol, tri(hydroxyethyl)ester of glycerol, and turkish red oil may be added.

A lithographic plate is thus obtained.

The invention will now be illustrated by the following example without however the intention to limit the invention thereto. All parts are by weight unless otherwise specified.

### EXAMPLE

### Preparation of the silver halide emulsion coating solution.

A gelatin silver halide emulsion was prepared using the double jet precipitation by mixing whilst stirring an aqueous solution of AgNO₃ having a concentration of 3 mole/l, and an aqueous solution having a concentration of 3 mole/l of NaCl and 0.054 mole/l of KBr. Before the precipitation 5*10⁻⁴ mole/l of sodium hexachlororhodaat was added to the alkali halide solution.

The temperature during the silver halide formation was 50°C. The obtained emulsion was cooled, flocculated and washed. Gelatin was added in an amount sufficient to reach a ratio of 2/3 by weight of gelatin to silver halide, expressed as equivalent amount of silver nitrate.

Subsequently a chemical ripening of the emulsion was carried out in a conventional way, known to those skilled in the art, by first adding 0.02 mole KI per mole AgNO₃ and subsequently thiosulphate and gold salts. A silver chlorobromoiodide emulsion composed of 98.0 mole% of chloride, 1.8 mole% of bromide and 0.2 mole% of iodide and containing Rhodium ions as internal dopant was so prepared. The average silver halide grain size was 0.4 µm (diameter of a sphere with equivalent volume). 4-hydroxy-6-methyl-1,3,3a,7-tetraazaindene was added as stabilizer in an amount of 290 mg/mole of silver halide.

Prior to coating the emulsion was green sensitised using a green sensitizing dye. Finally 1-phenyl-5-mercaptotetrazole (9.5*10⁻⁴ mole/mole of silver halide) and 7-sulpho-nafto-(2,3-d)-oxazolidine-2-thione (540 mg/mole of silver halide) were added to the emulsion.

A base layer coating solution was prepared having the following composition:

| | |
|---|---|
| gelatin | 5.5% |
| carbon black | 0.76% |
| silica particles (5µm) | 1.6% |

### Preparation of the imaging elements 1 and 2.

The emulsion coating solution was coated simultaneously with the base layer coating solution by means of the cascade coating technique to a subbed polyethylene terephthalate support provided with a pack of two backing layers such that the base layer coating was coated directly to the side of the support opposite to the side containing said backing layers. The emulsion layers were coated such that the silver halide coverage expressed as AgNO₃ was 1.25 g/m² and the gelatin content was 1.33 g/m². The emulsion layers further contained 0.35 g/m² of 1-phenyl-4,4'-dimethyl-3-pyrazolidone and 0.25 g/m² of hydroquinone. The base layer was coated such that the amount of gelatin in the coated layer was 3 g/m².

The first subbing layer on the backside comprised 3.1 mg/m² of an antistatic composition consisting of 2.2 mg/m² of polystyrene sulphonic acid and 0.9 mg/m² of poly(3,4-ethylenedioxy-thiophene).

The layer nearest to the support of the backing layer pack (first backing layer) contained 0.08 g/m² of gelatin. The second backing layer contained 2.8 g/m² of gelatin, 0.065 g/m² of a matting agent consisting of transparent spherical polymeric beads of 3 micron average diameter according to EP-A-080,225, 1.5 g/m² of dispersed barium sulfate (average diameter 0.3-0.4 µm), 3.0 g/m² of colloidal silica, 0.05 g/m² of hardening agent triacrylformal and 0.021 g/m² of wetting agent F₁₅C₇-COONH₄.

Two such elements were prepared, dried and subjected to a temperature of 40°C for 5 days and then the emulsion layer was overcoated for imaging element **1** with a layer containing PdS as physical development nuclei, hydroquinone at 0.4 g/m² and formaldehyde at 100 mg/m² and for imaging element **2** with a layer containing PdS as physical development nuclei, hydroquinone at 0.1 g/m² and formaldehyde at 100 mg/m²..

The following processing solutions were prepared :

| Activator | |
|---|---|
| sodium hydroxide (g) | 30 |
| sodium sulphite anh. (g) | 35 |
| potassium thiocyanate (g) | 20 |
| glycerine (ml) | 20 |
| 2-mercapto-5-n.heptyl-oxa-3,4-diazole (mg) | 200 |
| C₇F₁₅COONH₄ (mg) | 100 |
| carboxymethylcellulose (g) | 2 |
| hydroquinone (g) | 1 |
| ethylenediamine tetraacetic acid sodium salt (g) | 1 |
| water to make | 1 l |

Said solution had a viscosity at 25°C which was higher than 7 mPa s and a dynamic surface tension at 1 s and 25°C which was less than 40 mN/m.

| Neutralization solution | |
|---|---|
| citric acid | 10 g |
| sodium citrate | 35 g |
| sodium sulphite anh. | 5 g |
| phenol | 50 mg |
| water to make | 1 l |

The above described imaging element 1 was image-wise exposed and processed with the above described activator with a feed roller applying 120 ml of activator per m² of imaging element. In this way the molar amount of alkali applied per m² of imaging element is 12 times the molar amount of silver halide per m² in the imaging element and the total molar amount of hydroquinone applied per m² of imaging element and being present per m² is 0.94 times the molar amount of silver halide per m² in the imaging element. The imaging element is left in contact with the applied activator for 20 seconds at 30°C, subsequently neutralized at 25 °C with the neutralization solution described above and dried.

The obtained printing plate, prepared according to the invention was used for printing with a conventional ink and dampening solution. Prints with an excellent quality were obtained.

In a second experiment (comparison) the above described imaging element **1** was image-wise exposed and processed with the above described activator with a feed roller applying 25 ml of activator per m² of imaging element. In this way the molar amount of alkali applied per m² of imaging element is 2.5 times the molar amount of silver halide per m² in the imaging element and the total molar amount of hydroquinone applied per m² of imaging element and being present per m² is 0.83 times the molar amount of silver halide per m² in the imaging element. The imaging element is left in contact with the applied activator for 20 seconds at 30°C, subsequently neutralized at 25 °C with the neutralization solution described above and dried.

The obtained printing plate, prepared by a comparative method was used for printing with a conventional ink and dampening solution. Prints with a poor quality, showing streaks at the onset of the prints were obtained.

In a third experiment (comparison) the above described imaging element **2** was image-wise exposed and processed with the above described activator with a feed roller applying 120 ml of activator per m² of imaging element. In this way the molar amount of alkali applied per m² of imaging element is 12 times the molar amount of silver halide per m² in the imaging element and the total molar amount of hydroquinone applied per m² of imaging element and being present per m² is 0.58 times the molar amount of silver halide per m² in the imaging element. The imaging element is left in contact with the applied activator for 20 seconds at 30°C, subsequently neutralized at 25 °C with the neutralization solution described above and dried.

The obtained printing plate, prepared by a comparative method was used for printing with a conventional ink and dampening solution. Prints with a poor quality were obtained.

From this example it is clear that the method as herein described for obtaining a lithographic printing plate only gives good results when the molar amounts of alkali and of reducing agent present in the aqueous alkaline solution and in the imaging element are high enough (experiment 1). The method gives a poor result when either the amount of alkali is lower than required (second experiment) or when the total amount of reducing agent is lower than required (third experiment).

## Claims

1. A method for obtaining a lithographic printing plate according to the silver salt diffusion transfer process comprising the steps of:
(a) image-wise exposing an imaging element comprising on a support (i) a photosensitive layer comprising one or more silver halide emulsions and (ii) an image receiving layer containing physical development nuclei being in water permeable relationship with said photosensitive layer
(b) applying an aqueous alkaline solution to the imaging element in the presence of (a) developing agent(s) being applied by said aqueous alkaline and/or being present in the said imaging element and in the presence of (a) silver halide solvent(s) to form a silver image in said image receiving layer,
(c) optionally applying a neutralizing solution to the imaging element,
said aqueous alkaline solution being applied by a method in which said solution is supplied in a constant way only to the face of the imaging element on which a silver halide emulsion is applied, characterized in that said aqueous alkaline solution is applied in an amount so that the molar amount of alkali applied per m² is at least 3 times the molar amount of silver halide per m² in the imaging element and the total molar amount of developing agent applied per m² of imaging element and/or being present per m² in the imaging element is at least 0.60 times the molar amount of silver halide per m² in the imaging element.

2. A method according to claim 1 wherein said molar amount of alkali applied per m² is at least 5 times the molar amount of silver halide per m² in the imaging element.

3. A method according to claim 2 wherein said molar amount of alkali applied per m² is at least 7 times the molar amount of silver halide per m² in the imaging element.

4. A method according to any of claims 1 to 3 wherein said total molar amount of developing agent applied per m² of imaging element and/or being present per m² in the imaging element is at least 0.70 times the molar amount of silver halide per m² in the imaging element.

5. A method according to claim 4 wherein said total molar amount of developing agent applied per m² of imaging element and/or being present per m² in the imaging element is at least 0.80 times the molar amount of silver halide per m² in the imaging element.

6. A method according to any of claims 1 to 5 wherein said aqueous alkaline solution has a viscosity of at least 5 mPa s.

7. A method according to claim 6 wherein said aqueous alkaline solution comprises hydroxyethylcellulose or carboxymethylcellulose in an amount in the range between 1 and 10 g/l.

8. A method according to any of claims 1 to 7 wherein said aqueous alkaline solution has a dynamic surface tension at 1 s and at 25°C of at most 50 mN/m.

9. A method according to claim 8 wherein said aqueous alkaline solution comprises surface-active agents containing perfluorinated alkyl groups in an amount between 0.01 and 1 g/l.

## Patentansprüche

1. Verfahren zur Herstellung einer lithographischen Druckplatte nach dem Silbersalz-Diffusionsübertragungsverfahren, das die folgenden Stufen umfasst :
(a) bildmäßige Belichtung eines Bild erzeugenden Elements, das auf einem Träger (i) eine lichtempfindliche Schicht mit einer oder mehreren Silberhalogenidemulsionen sowie (ii) eine physikalische Entwicklungskeime enthaltende, in wasserdurchlässiger Beziehung zu der lichtempfindlichen Schicht befindliche Bildempfangsschicht umfasst
(b) Auftragen einer wässrigen alkalischen Lösung auf das Bild erzeugende Element in Gegenwart einer oder mehreren Entwicklersubstanzen, die von der wässrigen alkalischen Lösung aufgetragen werden und/oder in dem Bild erzeugenden Element enthalten sind, und in Gegenwart eines oder mehrerer Silberhalogenid-Lösungsmittel, wodurch in der Bildempfangsschicht ein Silberbild gebildet wird,
(c) gegebenenfalls Auftragen einer Neutralisierungslösung auf das Bild erzeugende Element,
wobei die wässrige alkalische Lösung aufgetragen wird nach einem Verfahren, nach dem die Lösung nur derjenigen Seite des Bild erzeugenden Elements, auf die eine Silberhalogenidemulsion aufgetragen wurde, kontinuierlich zugeführt wird,
dadurch gekennzeichnet, dass die wässrige alkalische Lösung in derartiger Menge aufgetragen wird, dass die Molmenge der aufgetragenen Alkalien pro m² wenigstens 3 mal so groß ist wie die Molmenge des Silberhalogenids pro m² in dem Bild erzeugenden Element, und dadurch, dass die gesamte Molmenge der Entwicklersubstanz die pro m² Bild erzeugendes Element aufgetragen wird und/oder pro m² in dem Bild erzeugenden Element enthalten ist, wenigstens 0,60 mal so groß ist wie die Molmenge des Silberhalogenids pro m² in dem Bild erzeugenden Element.

2. Verfahren nach Anspruch 1, dadurch gekennzeichnet, dass die Molmenge der aufgetragenen Alkalien pro m² wenigstens 5 mal so groß ist wie die Molmenge des Silberhalogenids pro m² in dem Bild erzeugenden Element.

3. Verfahren nach Anspruch 2, dadurch gekennzeichnet, dass die Molmenge der aufgetragenen Alkalien pro m² wenigstens 7 mal so groß ist wie die Molmenge des Silberhalogenids pro m² in dem Bild erzeugenden Element.

4. Verfahren nach einem der Ansprüche 1 bis 3, dadurch gekennzeichnet, dass die gesamte Molmenge der Entwicklersubstanz, die pro m² Bild erzeugendes Element aufgetragen wird und/oder pro m² in dem Bild erzeugenden Element enthalten ist, wenigstens 0,70 mal so groß ist wie die Molmenge des Silberhalogenids pro m² in dem Bild erzeugenden Element.

5. Verfahren nach Anspruch 4, dadurch gekennzeichnet, dass die gesamte Molmenge der Entwicklersubstanz die pro m² Bild erzeugendes Element aufgetragen wird und/oder pro m² in dem Bild erzeugenden Element enthalten ist, wenigstens 0,80 mal so groß ist wie die Molmenge des Silberhalogenids pro m² in dem Bild erzeugenden Element.

6. Verfahren nach einem der Ansprüche 1 bis 5, dadurch gekennzeichnet, dass die wässrige alkalische Lösung eine Viskosität von wenigstens 5 mPa s aufweist.

7. Verfahren nach Anspruch 6, dadurch gekennzeichnet, dass die wässrige alkalische Lösung Hydroxyethylcellulose oder Carboxymethylcellulose in einer Menge im Bereich von 1 bis 10 g/l enthält.

8. Verfahren nach einem der Ansprüche 1 bis 7, dadurch gekennzeichnet, dass die wässrige alkalische Lösung bei 1 s und 25°C eine dynamische Oberflächenspannung von höchstens 50 mN/m aufweist.

9. Verfahren nach Anspruch 8, dadurch gekennzeichnet, dass die wässrige alkalische Lösung perfluorierte Alkylgruppen enthaltende Tenside in einer Menge zwischen 0,01 und 1 g/l enthält.

## Revendications

1. Procédé de confection de clichés d'impression lithographique conformément au procédé de transfert de sels d'argent par diffusion, comprenant les étapes consistant à:
(a) exposer en forme d'image un élément formateur d'images comprenant, sur un support, (i) une couche photosensible contenant une ou plusieurs émulsions aux halogénures d'argent et (ii) une couche réceptrice d'images, qui contient des germes de développement physique et qui se trouve en relation de perméabilité à l'eau avec ladite couche photosensible,
(b) appliquer une solution alcaline aqueuse sur l'élément formateur d'images en présence d'un ou de plusieurs agents développateurs appliqués par ladite solution alcaline aqueuse et/ou contenus dans ledit élément formateur d'images, et en présence d'un ou de plusieurs solvants des halogénures d'argent, pour former une image argentique dans ladite couche réceptrice d'images,
(c) appliquer le cas échéant une solution de neutralisation sur l'élément formateur d'images,
ladite solution alcaline aqueuse étant appliquée conformément à un procédé, dans lequel ladite solution est apportée continuellement uniquement sur la face de l'élément formateur d'images, qui a été enduite d'une émulsion aux halogénures d'argent,
caractérisé en ce que ladite solution alcaline aqueuse est appliquée en quantité telle que la quantité molaire des alcalis appliqués par mètre carré soit au moins 3 fois plus grande que la quantité molaire des halogénures d'argent par mètre carré dans l'élément formateur d'images et en ce que la quantité molaire totale de l'agent développateur appliqué par mètre carré de l'élément formateur d'images et/ou contenu par mètre carré dans l'élément formateur d'images soit au moins 0,60 fois plus grande que la quantité molaire des halogénures d'argent par mètre carré dans l'élément formateur d'images.

2. Procédé selon la revendication 1, caractérisé en ce que la quantité molaire des alcalis appliqués par mètre carré soit au moins 5 fois plus grande que la quantité molaire des halogénures d'argent par mètre carré dans l'élément formateur d'images.

3. Procédé selon la revendication 2, caractérisé en ce que la quantité molaire des alcalis appliqués par mètre carré soit au moins 7 fois plus grande que la quantité molaire des halogénures d'argent par mètre carré dans l'élément formateur d'images.

4. Procédé selon l'une quelconque des revendications 1 à 3, caractérisé en ce que la quantité molaire totale de l'agent développateur appliqué par mètre carré de l'élément formateur d'images et/ou contenu par mètre carré dans l'élément formateur d'images soit au moins 0,70 fois plus grande que la quantité molaire des halogénures d'argent par mètre carré dans l'élément formateur d'images.

5. Procédé selon la revendication 4, caractérisé en ce que la quantité molaire totale de l'agent développateur appliqué par mètre carré de l'élément formateur d'images et/ou contenu par mètre carré dans l'élément formateur d'images soit au moins 0,80 fois plus grande que la quantité molaire des halogénures d'argent par mètre carré dans l'élément formateur d'images.

6. Procédé selon l'une quelconque des revendications 1 à 5, caractérisé en ce que ladite solution alcaline aqueuse possède une viscosité d'au moins 5 mPa s.

7. Procédé selon la revendication 6, caractérisé en ce que ladite solution alcaline aqueuse contient de la cellulose hydroxyéthylique ou carboxyméthylique dans une quantité comprise entre 1 et 10 g/l.

8. Procédé selon l'une quelconque des revendications 1 à 7, caractérisé en ce que ladite solution alcaline aqueuse possède à 1 s et à 25°C une tension superficielle dynamique de 50 mN/m maximum.

9. Procédé selon la revendication 8, caractérisé en ce que ladite solution alcaline aqueuse contient des agents tensioactifs contenant des groupes alkyle perfluorés dans une quantité comprise entre 0,01 et 1 g/l.
